# EUROPEAN PATENT SPECIFICATION

(11) **EP 0 509 615 B1**
(45) Date of publication and mention of the grant of the patent: **26.06.1996**
(21) Application number: 92201966.6
(22) Date of filing: 10.04.1991
(51) Int. Cl.: H01L 31/0224, H01L 31/068

(54) **Solar cell**
Solarzelle
Cellule solaire

(30) Priority: 13.04.1990 JP 98802/90
(43) Date of publication of application: 21.10.1992
(62) Divisional of application: 91303176.1
(73) Proprietor: MITSUBISHI DENKI KABUSHIKI KAISHA, Tokyo (JP); NIPPON TELEGRAPH AND TELEPHONE CORPORATION, Tokyo (JP)
(72) Inventor: Oohara, Takahiko, Higashimurayama-shi, Tokyo (JP); Ohmachi, Yoshiro, Higashiyamato-shi, Tokyo (JP); Kadota, Yoshiaki, Ebina-shi, Kanagawa-ken (JP); Mitsui, Kotaro, c/o Mitsubishi Denki K. K., 4-chome, Itami-shi, Hyogo-ken (JP); Ogasawara, Nobuyoshi, c/o Mitsubishi Denki K.K., 4-chome, Itami-shi, Hyogo-ken (JP); Nishimura, Takashi, c/o Mitsubishi Denki K. K., 4-chome, Itami-shi, Hyogo-ken (JP)
(74) Representative: Beresford, Keith Denis Lewis

(56) References cited:
- CONFERENCE RECORD OF THE 19TH IEEE PHOTOVOLTAIC SPECIALISTS CONFERENCE, 4 May 1987, NEW ORLEANS, LOUISIANA, US, pp. 338-334 ; T. O'HARA ET AL.: 'HIGH EFFICIENCY GaAs SOLAR CELLS FABRICATED ON Si SUBSTRATES'
- JOURNAL OF APPLIED PHYSICS, vol. 65, no. 9, 1 May 1989, NEW YORK, US, pp. 3680-3686 ; A.P. SILARD ET AL.: 'DEVELOPMENTAL EXPERIMENTS ON LARGE-AREA SILICON SOLAR CELLS'
- JAPANESE JOURNAL OF APPLIED PHYSICS, vol. 21, no. 6-P1, June 1982, TOKYO, JP, pp. 950-954 ; K. MITSUI ET AL.: 'AN A1GaAs/GaAs CONCENTRATOR SOLAR CELL OPERATING AT HIGH CONCENTRATION RATIOS WITHOUT FORCED COOLING'
- PATENT ABSTRACTS OF JAPAN, vol. 13, no. 307 (E-787), 24 September 1987 ; & JP-A-01 082 572

## Description

### FIELD OF THE INVENTION

The present invention relates to a GaAs solar cell on an Si substrate.

### BACKGROUND OF THE INVENTION

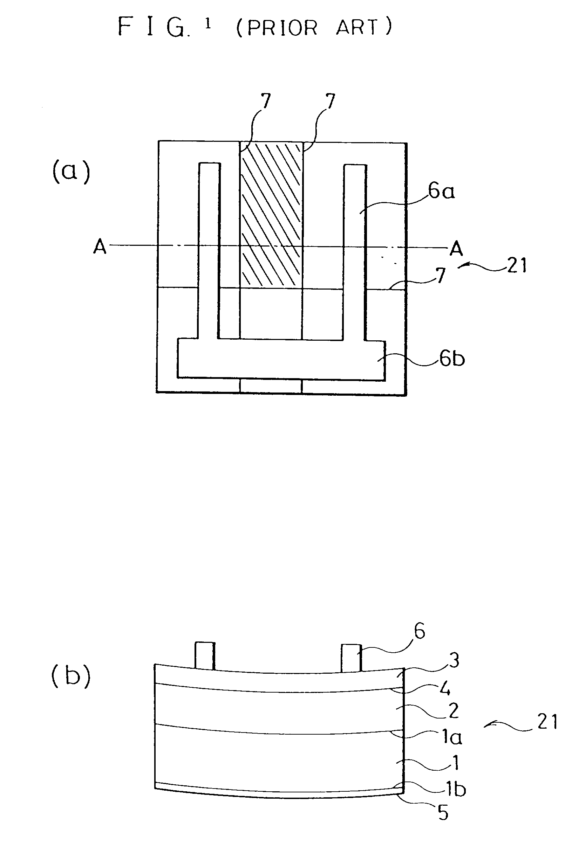

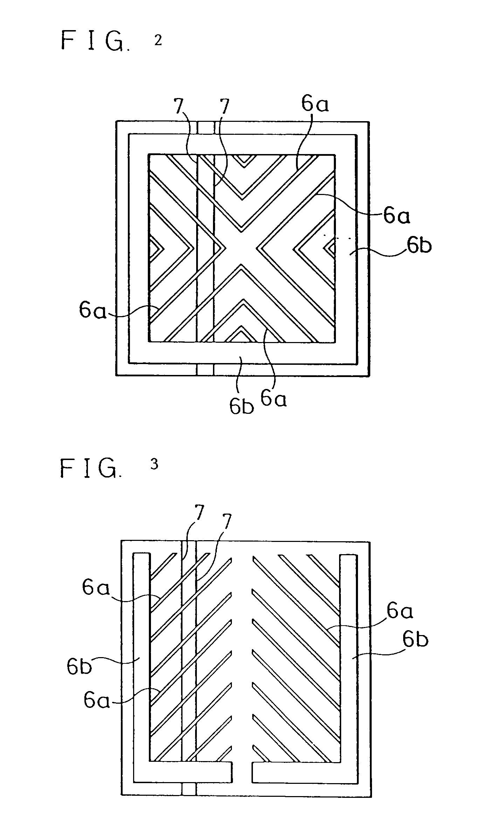

Figures 1(a) and (b) are views showing a structure of a conventional GaAs solar cell on an Si substrate, in which figure 1(a) is its plan view and figure 1(b) is a sectional view taken along a line A-A in figure 1(a). In figure 1, reference numeral 1 designates an Si substrate. An n type GaAs layer 2 and a p type GaAs layer 3 which serve as active layers are laminated on a first main surface la of the Si substrate 1 and then an anode electrode (p type electrode) 6 is formed on the p type GaAs layer 3 and a cathode electrode (n type electrode) 5 is provided on a second main surface 1b of the Si substrate 1. Thus, a solar cell 21 is formed.

The GaAs solar cell 21 on the Si substrate is normally manufactured by the following method.

First, the n type GaAs layer 2 and the p type GaAs layer 3 are sequentially formed on the first main surface la of the n type Si substrate 1 having a surface orientation of approximately (100) by a method of crystal growth of a compound semiconductor, such as MOCVD method. Thus, a pn junction 4 which generates a photovoltaic effect is formed. Then, as an electrode for taking a photoelectromotive force out, the anode electrode (p side electrode) 6 is selectively formed on the p type GaAs and the cathode electrode (n side electrode) 5 is formed on the whole surface of the second main surface 1b of the Si substrate 1. The anode electrode 6 comprises collecting electrodes 6a for collecting a photoelectric current and a common electrode 6b for connecting the collecting electrodes to an outside circuit. These electrodes are formed by sputtering or a vapour deposition method and Ti/Ag is normally used as their materials.

However, a conventional GaAs solar cell on a Si substrate has the following problems. That is, since the n type GaAs layer 2 and the p type GaAs layer 3 are usually formed at a high temperature of 700 to 800°C, when the wafer on which the above GaAs layers are formed is taken out at room temperature, a large warpage is generated because of a difference in thermal expansion coefficient between GaAs and Si, as shown in figure 1(b). As the thickness of the GaAs layer is increased, the degree of this warpage becomes large. When the thickness of the GaAs layer exceeds 3 µm, a crack is generated. On the other hand, as the thickness of the GaAs layer is increased, the dislocation density in the GaAs layer is reduced. Therefore, in order to assure sufficient performance as the solar cell, the thickness should be 4 to 5 µm. Thus, cracks are generated in the operation layer (active layer) of the conventional solar cell. Particularly, a region surrounded by cracks 7 on which no collecting electrode 6a is provided, which region is shown by slanting lines in figure 1 (a), is a loss region because the generated photoelectric current cannot be collected.

In addition, even if cracks are not generated in the initial stage of production, since considerably large thermal stress remains in the GaAs layer, when slight stress is applied from the outside, cracks are easily generated in the GaAs layer. Since the warpage is concave when the GaAs layer is on the upper side as shown in figure 1(b), cracks are easily generated when a stress is applied from the direction of the second main surface 1b of the Si substrate, that is, when a tensile stress is applied to the GaAs layer. Therefore, when the wafer is flattened in a photolithography process for patterning the p type electrode 6 or when interconnector welding for modulation is performed on the first electrode 5 side in an assembling process, cracks are surely generated.

Japanese patent application 01082572 discloses a construction of GaAs solar cell in which the front electrode comprises a collecting electrode the portions of which are connected to a common electrode. The portions of the collecting electrode and the conmon electrode are perpendicular to each other and both are oblique to any cracks.

The present invention has been devised to solve the above problems and it is therefore an object of the present invention, which is defined in the appended claims, to provide a GaAs solar cell on an Si substrate in which a satisfactory photocurrent collection efficiency is achieved notwithstanding crack generation.
Figures 1(a) and 1(b) are a plan and section of a conventional GaAs solar cell.
Figure 2 is a plan view showing a GaAs solar cell on an Si substrate in accordance with an embodiment of the present invention; and
Figure 3 is a plan view showing a GaAs solar cell on an Si substrate in accordance with a variation of the above embodiment.

### DETAILED DESCRIPTION OF THE PREFERRED EMBODIMENT

The prior art has been discussed above, with reference to Figure 1. Referring now to Figure 2, this figure is a view showing a solar cell in accordance with an embodiment of the present invention. The common electrode 6b is formed on four sides in the vicinity of tne element so that it is parallel or perpendicular to the crystallographic direction in which cracks 7 will occur (hereinafter referred to as cleavage direction). The collecting electrodes 6a oblique to the cleavage direction 7 are connected to each lining of the common electrode 6b. It is thus possible to collect the photoelectric current generated at a region surrounded by two cracks 7. Thus, according to this embodiment of the present invention, the influence of cracks can be reduced.

Figure 3 is a view showing a solar cell in accordance with a variation of the preferred embodiment of the present invention. According to this variation also, two common electrodes 6b are provided, again parallel or perpendicular to the cleavage direction 7, and the collecting electrodes 6a are connected to each of the common electrodes at angles other than 90° so that the collecting electrodes 6a may cross the cracks 7. In this case, when the orientation of the GaAs crystal surface is {100}, cracks are likely to be generated in a <100> direction. Then, if the common electrodes 6b are arranged in a <100> direction, the collecting electrodes 6a which do not cross at a right angle to the common electrodes 6b do not cross at a right angle to the cracks 7. As a result, it is possible to collect the photoelectric current also from regions bounded by two or more cracks 7 and so the influence of cracks is reduced.

Although the present invention has been described and illustrated in detail, it is clearly understood that the same is by way of illustration and example only and is not to be taken by way of limitation, the scope of the present invention being limited only by the terms of the appended claims.

## Claims

1. A solar cell comprising:
at least a GaAs layer (2) of a first conductivity type and a GaAs layer of a second conductivity type (3) formed on a first main surface of a first conductivity type Si substrate (1);
a first electrode (5) formed on a second main surface opposite to the first main surface of said Si substrate; and
a second electrode (6) formed on said second conductivity type GaAs layer,
said second electrode being patterned into a configuration comprising a collecting electrode (6a) the portions of which are connected to a common electrode (6b), the collecting electrode being oblique to the crack directions (7) of the GaAs layer and to the common electrode, characterised in that the common electrode is parallel and/or perpendicular to the crack directions (7).

2. A solar cell in accordance with claim 1, wherein at least two common electrodes (6b) are formed on one element.

## Patentansprüche

1. Eine Solarzelle mit:
wenigstens einer GaAs-Schicht (2) eines ersten Leitfähigkeitstyps und einer GaAs-Schicht eines zweiten Leitfähigkeitstyps (3), die auf einer ersten Hauptoberfläche eines Si-Substrates (1) eines ersten Leitfähigkeitstyps ausgebildet sind;
einer ersten Elektrode (5), die auf einer zweiten Hauptoberfläche gegenüber der ersten Hauptoberfläche des Si-Substrates ausgebildet ist; und
einer zweiten Elektrode (6), die auf der GaAs-Schicht des zweiten Leitfähigkeitstyps ausgebildet ist,
wobei die zweite Elektrode in einer Konfiguration gemustert ist mit einer Sammelelektrode (6a), deren Abschnitte mit einer gemeinsamen Elektrode (b) verbunden sind, wobei die Sammelelektrode schräg zu den Rißrichtungen (7) auf der GaAs-Schicht und zu der gemeinsamen Elektrode sind, dadurch gekennzeichnet, daß die gemeinsame Elektrode parallel und/oder senkrecht zu den Rißrichtungen (7) ist.

2. Eine Solarzelle nach Anspruch 1, wobei wenigstens zwei gemeinsame Elektroden (6b) auf einem Element ausgebildet sind.

## Revendications

1. Cellule solaire comprenant :
au moins une couche de GaAs (2) d'un premier type de conductivité et une couche de GaAs d'un second type de conductivité (3) formées sur une première surface principale d'un substrat (1) de Si d'un premier type de conductivité;
une première électrode (5) formée sur une seconde surface principale opposée à la première surface principale dudit substrat de Si; et
une seconde électrode (6) formée sur ladite couche de GaAs du second type de conductivité,
ladite seconde électrode étant formée en une configuration comprenant une électrode de collecte (6a) dont les portions sont connectées à une électrode commune (6b), l'électrode de collecte étant oblique par rapport aux directions (7) de fissures de la couche de GaAs et à l'électrode commune, caractérisée en ce que l'électrode commune est parallèle et/ou perpendiculaire aux directions de fissure (7).

2. Cellule solaire selon la revendication 1, où au moins deux électrodes communes (6b) sont formées sur un élément.
